(19)

**Europäisches Patentamt**
**European Patent Office**
**Office européen des brevets**

(11)  **EP 4 651 694 A1**

(12)  # EUROPEAN PATENT APPLICATION
published in accordance with Art. 153(4) EPC

(43) Date of publication:
**19.11.2025 Bulletin 2025/47**

(21) Application number: **24795711.1**

(22) Date of filing: **20.03.2024**

(51) International Patent Classification (IPC):
**H10K 59/80** (2023.01)

(52) Cooperative Patent Classification (CPC):
**H10K 59/12; H10K 59/80**

(86) International application number:
**PCT/CN2024/082619**

(87) International publication number:
**WO 2024/222328 (31.10.2024 Gazette 2024/44)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.04.2023 CN 202310485396**

(71) Applicants:
• **Boe Technology Group Co., Ltd.**
  **Beijing 100015 (CN)**
• **Beijing BOE Technology Development Co., Ltd.**
  **Beijing 100176 (CN)**

(72) Inventors:
• **XIAN, Jianbo**
  **Beijing 100176 (CN)**
• **XU, Jingbo**
  **Beijing 100176 (CN)**
• **WANG, Jingquan**
  **Beijing 100176 (CN)**
• **QIAO, Yong**
  **Beijing 100176 (CN)**
• **WU, Xinyin**
  **Beijing 100176 (CN)**

(74) Representative: **Durán-Corretjer, S.L.P.**
**Còrsega, 329**
**(Paseo de Gracia/Diagonal)**
**08037 Barcelona (ES)**

(54)  **DISPLAY SUBSTRATE AND DISPLAY APPARATUS**

(57)  A display substrate and a display apparatus. The display substrate comprises a display area and a bezel area located on the periphery of the display area; the display area comprises a plurality of sub-pixels provided on a substrate; each sub-pixel comprises a light-emitting element, each light-emitting element comprising a first electrode, a light-emitting functional layer and a second electrode layer which are successively stacked in a direction away from the substrate; the bezel area is provided with at least one heat dissipation structure; the heat dissipation structure comprises a first heat dissipation recess and, provided in the first heat dissipation recess, a first heat dissipation metal layer and a second heat dissipation metal layer, the second heat dissipation metal layer being stacked on the side of the first heat dissipation metal layer away from the substrate, and the second heat dissipation metal layer and the second electrode layer being arranged on the same layer.

Fig.4

EP 4 651 694 A1

## Description

The present application claims priority of Chinese Patent Application No. 202310485396.2, filed to the CNIPA on April 28, 2023 and entitled "Display Substrate and Display Apparatus", the content of which should be regarded as being incorporated herein by reference.

Technical Field

Embodiments of the present disclosure relate to, but are not limited to, the display field, and particularly relate to a display substrate and a display apparatus.

Background

At present, in the display field, Gate Driver on Array (GOA) technology is widely used because it can simplify the process and reduce the cost. The GOA technology integrates a gate drive circuit including a plurality of thin film transistors (TFTs) on an array substrate to form a scan drive for sub-pixels. A width-length ratio of a channel of an output transistor in the gate drive circuit is usually relatively large, so the output transistor will generate a large amount of heat during operation. The dissipation of the heat will cause a threshold voltage of a thin film transistor in a pixel drive circuit of sub-pixels around a display region to drift negatively, and thereby will result in the case that the sub-pixels around the display region are brightened up, affecting the display effect.

Summary

The following is a summary of subject matters described herein in detail. This summary is not intended to limit the protection scope of claims.

An embodiment of the present disclosure provides a display substrate, including a display region and a bezel region located around the display region. The display region includes a plurality of sub-pixels disposed on a base substrate, and a sub-pixel includes a light emitting element, the light emitting element including a first electrode, a light emitting functional layer and a second electrode layer sequentially stacked in a direction away from the base substrate. The bezel region is provided with at least one heat dissipation structure, and the heat dissipation structure includes a first heat dissipation groove, and a first heat dissipation metal layer and a second heat dissipation metal layer arranged in the first heat dissipation groove. The second heat dissipation metal layer is stacked on a side of the first heat dissipation metal layer away from the base substrate, and the second heat dissipation metal layer is disposed in the same layer as the second electrode layer.

An embodiment of the present disclosure further provides a display apparatus including the display substrate described above.

Other aspects of the present disclosure may be comprehended after the drawings and the detailed descriptions are read and understood.

Brief Description of Drawings

Accompanying drawings are intended to provide further understanding of technical solutions of the present disclosure and form a part of the specification, and are used to explain the technical solutions of the present disclosure together with embodiments of the present disclosure, but do not form limitations on the technical solutions of the present disclosure. Shapes and sizes of components in the drawings do not reflect actual scales, and are only intended to schematically illustrate contents of the present disclosure.

FIG. 1 is a schematic diagram of a planar structure of a display substrate according to some exemplary embodiments.

FIG. 2 is a schematic diagram of a partial planar structure of a display substrate according to some exemplary embodiments.

FIG. 3 is an equivalent circuit diagram of a pixel drive circuit according to some exemplary embodiments;

FIG. 4 is a schematic diagram of a partial cross-sectional structure of a display substrate according to some exemplary embodiments.

FIG. 5 is a schematic diagram of a partial cross-sectional structure of a display substrate according to some other exemplary embodiments.

FIG. 6 is a schematic diagram of a partial cross-sectional structure of a display substrate according to some further exemplary embodiments.

FIG. 7 is a schematic diagram of a partial cross-sectional structure of a display substrate according to some further exemplary embodiments.

FIG. 8 is a schematic diagram of a partial cross-sectional structure of a display substrate according to some further exemplary embodiments.

FIG. 9 is a schematic diagram of a partial cross-sectional structure of a display substrate according to some further exemplary embodiments.

FIG. 10 is a schematic diagram of a partial planar structure of a display substrate according to some other exemplary embodiments.

FIG. 11 is a schematic diagram of a partial planar structure of a display substrate according to some further exemplary embodiments.

FIG. 12 is a schematic diagram of a partial planar structure of a display substrate according to some further exemplary embodiments.

FIG. 13 is a schematic diagram of a partial planar structure of a display substrate according to some exemplary embodiments.

FIG. 14 is a schematic diagram of a partial planar structure of a display substrate according to some exemplary embodiments.

Reference signs: 10- base substrate, 20- drive structure layer, 21- buffer layer, 22- gate insulation layer, 23- interlayer insulation layer, 24- passivation layer, 25- planarization layer, 30-light emitting structure layer, 31- first electrode, 32- pixel definition layer, 33- organic light emitting layer, 34- second electrode layer, 41- black matrix, 42- color filter layer, 70- heat insulation groove, 71- second signal line, 80- heat dissipation structure, 81- first heat dissipation metal layer, 82- second heat dissipation metal layer, 83- third heat dissipation metal layer, 84-fourth heat dissipation metal layer, 85- filling layer, 87- first heat dissipation groove, 88- second heat dissipation groove;

100- display region, 200- bezel region, 210- transistor, 211- active layer, 212- gate electrode, 213- source electrode, 214- drain electrode, 220- gate drive circuit, 221- gate drive unit, 231- light shielding block, 232- data line, 240- gate connection line, 241- first connection line, 242- second connection line, 243- via, 421- filter unit, 801- first heat dissipation structure, 802- second heat dissipation structure, 803- third heat dissipation structure, 804- fourth heat dissipation structure, 805- fifth heat dissipation structure, 806- sixth heat dissipation structure, 807- seventh heat dissipation structure, 808- eighth heat dissipation structure, 809- ninth heat dissipation structure, 831- first sub-heat dissipation metal layer, 832- second sub-heat dissipation metal layer, 851- first sub-filling layer, 852- second sub-filling layer, 853- third sub-filling layer;

2211- input module, 2212- output transistor, 2213- output capacitor, 2214- pull-down transistor, 2402- second gate connection line, 2403- third gate connection line.

Detailed Description

Those of ordinary skills in the art should understand that modifications or equivalent replacements may be made to the technical solutions of the embodiments of the present disclosure without departing from the spirit and scope of the technical solutions of the embodiments of the present disclosure, and should all fall within the scope of the claims of the present disclosure.

In the accompanying drawings, a size of a constituent element, and a thickness of a layer or a region are sometimes exaggerated for clarity. Therefore, an implementation of the present disclosure is not necessarily limited to the size, and the shape and size of each component in the drawings do not reflect an actual scale. In addition, the drawings schematically illustrate some examples, and an implementation of the present disclosure is not limited to the shapes or numerical values shown in the drawings.

In the description herein, "parallel" refers to a state in which an angle formed by two straight lines is above -10° and below 10°, and thus includes a state in which the angle is above -5° and below 5°. In addition, "perpendicular" refers to a state in which an angle formed by two straight lines is above 80° and below 100°, and thus includes a state in which the angle is above 85° and below 95°.

In the present disclosure, for convenience, the expressions "central", "above", "below", "front", "back", "vertical", "horizontal", "top", "bottom", "inside", "outside" and the like for indicating orientations or positional relationships are used for describing positional relationships between constituent elements with reference to the drawings. They are only for convenience of describing this specification and simplifying description, and do not indicate or imply that involved apparatuses or elements must have specific orientations or are structured and operated with the specific orientations, and thus should not be understood as limitations to the present disclosure. The positional relationships between the constituent elements may be changed as appropriate based on a direction according to which each constituent element is described. Therefore, appropriate replacements based on situations are allowed, which is not limited to the expressions in the specification.

In the description herein, unless otherwise specified and defined explicitly, terms "connection", "fixed connection", "installation", and "assembly" should be understood in a broad sense. For example, it may be a fixed connection, a detachable connection, or an integrated connection; terms "installation", "connection", and "fixed connection" may be a direct connection, an indirect connection through an intermediary, or an internal communication between two elements. For those ordinarily skilled in the art, meanings of the above terms in the embodiments of the present disclosure may be understood according to situations.

Ordinal numerals such as "first", "second", and "third" herein are set to avoid confusion between constituent elements, but are not intended to limit in terms of quantity.

Herein, a transistor refers to an element at least including three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. Herein, the channel region refers to a region through which the current mainly flows.

Herein, a first pole of the transistor may be a drain electrode, and a second pole of the transistor may be a source electrode, or the first pole may be a source electrode, and the second pole may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode" are interchangeable herein.

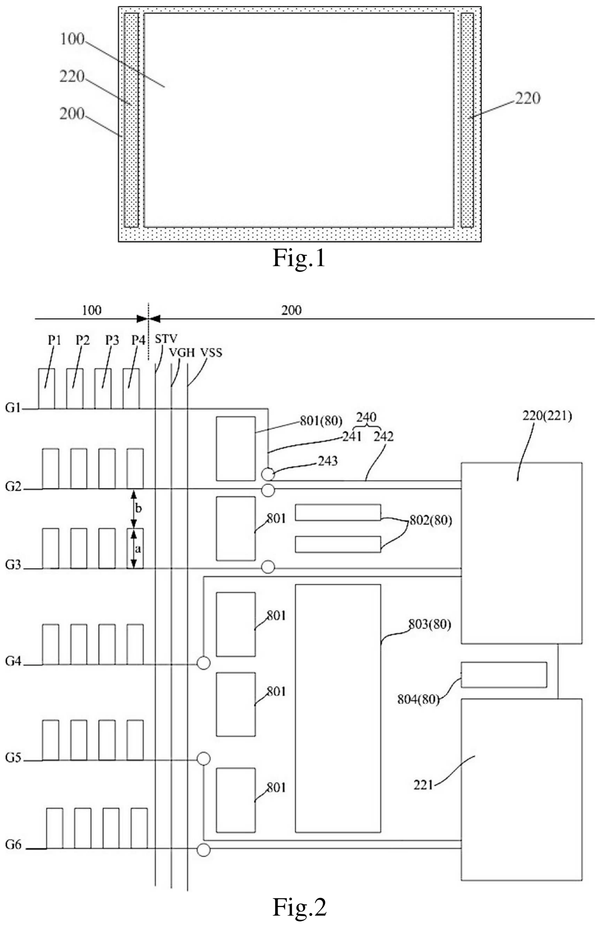

As shown in FIGS. 1 and 2, FIG. 1 is a schematic diagram of a planar structure of a display substrate according to some exemplary embodiments, and FIG. 2 is a schematic diagram of a partial planar structure of a display substrate according to some exemplary embodiments. The display substrate includes a display region 100 and a bezel region 200 located around the display region 100.

The display region 100 includes a plurality of sub-pixels arranged in an array on a base substrate, and each sub-pixel includes a light emitting element and a pixel drive circuit connected to the light emitting element. The display region 100 further includes a plurality of gate lines extending along a first direction (six gate lines G1 to G6 are schematically shown in FIG. 2) and a plurality of data lines (not shown) extending along a second direction (a vertical direction in the figure), and a pixel drive circuit of each sub-pixel is electrically connected to the gate lines and the data lines.

The plurality of sub-pixels may include a plurality of first sub-pixels P1 that emit light of a first color, a plurality of second sub-pixels P2 that emit light of a second color, and a plurality of third sub-pixels P3 that emit light of a third color. For example, a first sub-pixel P1 may emit red light, a second sub-pixel P2 may emit green light, and a third sub-pixel P3 may emit blue light. In other examples, the plurality of sub-pixels of the display region 100 may further include a plurality of fourth sub-pixels P4 that emit light of a fourth color, and a fourth sub-pixel P4 may emit white light, or yellow light, etc. An embodiment of the present disclosure does not limit the type and arrangement of the plurality of sub-pixels in the display region 100.

The light emitting element may be any of a light emitting diode (LED), an organic light emitting diode (OLED), a quantum-dot light emitting diode (QLED), and a micro-LED (including: a mini-LED or a micro-LED). For example, the light emitting element may be an OLED, an OLED light emitting element may include an anode, a light emitting functional layer and a cathode that are stacked, and the anode of the light emitting element may be electrically connected to a corresponding pixel drive circuit.

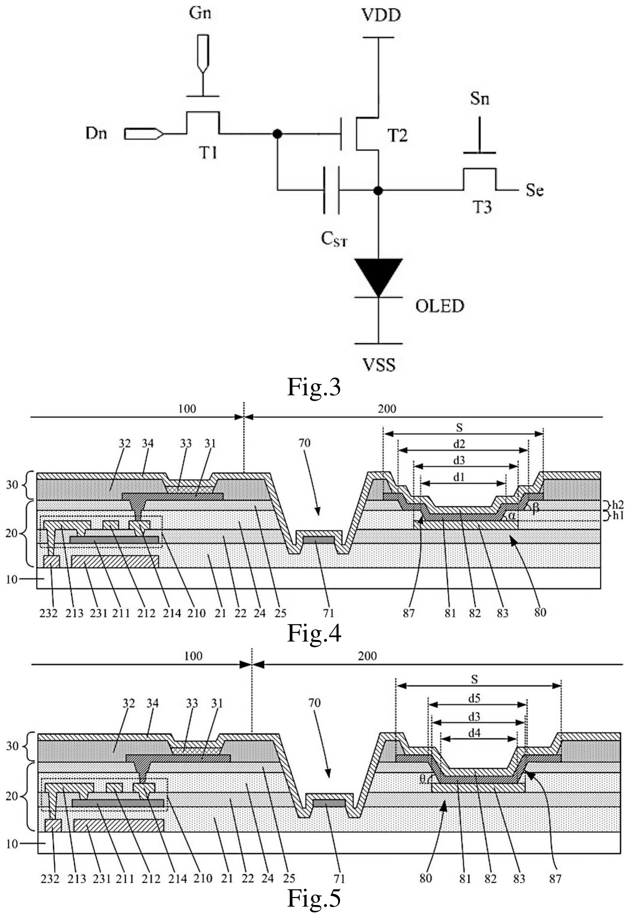

The pixel drive circuit may include a plurality of transistors and at least one storage capacitor, for example, the pixel drive circuit may be a 3T1C, 4T1C, 5T1C, 5T2C, 6T1C, 7T1C, or 8T1C structure, wherein T refers to a thin film transistor and C refers to a storage capacitor. An embodiment of the present disclosure does not limit a structure of the pixel drive circuit. For example, as shown in FIG. 3, FIG. 3 is an equivalent circuit diagram of a pixel drive circuit according to some exemplary embodiments. The pixel drive circuit may be a 3T1C structure, and the pixel drive circuit includes a first transistor T1, a second transistor T2, a third transistor T3, and a storage capacitor $C_{ST}$. The light emitting element may be an OLED light emitting element. The pixel drive circuit is connected to a data signal line Dn, a first scan signal line Gn, a second scan signal line Sn, a compensation signal line Se, a first power supply line VDD and a second power supply line VSS of the display region. Herein, the data signal line Dn namely is a data line, and the first scan signal line Gn and the second scan signal line Sn may be the same gate line or two different gate lines. The first scan signal line Gn and the second scan signal line Sn may extend along the first direction, and the data signal line Dn, the compensation signal line Se, the first power supply line VDD, and the second power supply line VSS may all extend along the second direction. The first transistor T1 is a switching transistor, the second transistor T2 is a drive transistor, and the third transistor T3 is a compensation transistor. A gate electrode of the first transistor T1 is connected with the first scan line Gn, a first pole of the first transistor T1 is connected with the data line Dn, and a second pole of the first transistor T1 is connected with a gate electrode of the second transistor T2. The first transistor T1 is used for receiving, under control of the first scan line Gn, a data signal transmitted by the data line Dn, so that the gate electrode of the second transistor T2 receives the data signal. The gate electrode of the second transistor T2 is connected with the second pole of the first transistor T1, a first pole of the second transistor T2 is connected with the first power supply line VDD, and a second pole of the second transistor T2 is connected with a first pole (anode) of an OLED. The second transistor T2 is used for generating, under control of the data signal received by the gate electrode thereof, a corresponding current at the second pole. A gate electrode of the third transistor T3 is connected with the second scan line Sn, a first pole of the third transistor T3 is connected with the compensation signal line Se, and a second pole of the third transistor T3 is connected with the second pole of the second transistor T2. The third transistor T3 is used for extracting a threshold voltage Vth and a mobility of the second transistor T2 in response to a compensation timing so as to compensate the threshold voltage Vth. The first pole of the OLED is connected with the second pole of the second transistor T2, and a second pole (cathode) of the OLED is connected with the second power supply line VSS. The OLED is used for emitting light with corresponding brightness in response to the current of the second pole of the second transistor T2. A first pole of the storage capacitor $C_{ST}$ is connected with the gate electrode of the second transistor T2, and a second pole of the storage capacitor $C_{ST}$ is connected with the second pole of the second transistor T2. The storage capacitor $C_{ST}$ is used for storing a potential of the gate electrode of the second transistor T2. A signal of the first power supply line VDD is a continuously provided high-level signal and a signal of the second power supply line VSS is a low-level signal. A maximum voltage of the data signal transmitted by the data line Dn may be less than a maximum voltage of the first scan line Gn and also less than a voltage of the first power supply line VDD. The first transistor T1 to the third transistor T3 may be P-type transistors or N-type transistors.

The bezel region 200 includes a first bezel region and a second bezel region located on opposite sides of the display region 100. The first bezel region or/and the second bezel region are provided with a gate drive circuit 220, and the gate drive circuit 220 includes a plurality of cascaded gate drive units 221 (which may be referred to as GOA units) configured to provide drive signals to a plurality of gate lines. Each gate drive unit 221 may be connected to one or more gate lines. The gate drive unit 221 may include a plurality of transistors and at least one storage capacitor, and an embodiment of the present disclosure does not limit a structure of the gate drive unit 221.

The bezel region 200 is further provided with a gate connection line 240, and a gate line of the display region 100 is connected to the gate drive unit 221 through the gate connection line 240. The gate connection line 240 includes a first connection line 241 and a second connection line 242 connected through a via 243, and the first connection line 241 is integrally connected to the gate line and the second connection line 242 is connected to the gate drive unit 221. An extending direction of the first connection line 241 may be the same as an extending direction of the gate line, or the first connection line 241 may include a first line segment and a second line segment connected to each other, an extending direction of the first line segment is the same as an extending direction of the gate line, and an extending direction of the second line segment may be perpendicular to the extending direction of the gate line.

The bezel region 200 is further provided with one or more heat dissipation structures 80. For example, an orthographic projection of at least one of the heat dissipation structures 80 on the base substrate 10 may be located between orthographic projections of the display region 100 and the gate drive circuit 220 on the base substrate 10. That is, in a direction parallel to the base substrate 10, the at least one of the heat dissipation structures 80 may be located between the display region 100 and the gate drive circuit 220. In this way, the heat generated by the gate drive unit 221 can be conducted out through the heat dissipation structure, and the conduction of heat to the display region 100 is reduced, so that the effect of the heat generated by the gate drive unit 221 (output transistor) on a sub-pixel at an edge of the display region 100 is reduced. Consequently, the problem of display abnormality (peripheral sub-pixels are brightened up) caused by the effect of the heat generated by the gate drive unit 221 on the peripheral sub-pixels of the display region 100 can be improved.

In some exemplary embodiments, as shown in FIG. 2, the plurality of heat dissipation structures 80 may include any one or more of at least one first heat dissipation structure 801, at least one second heat dissipation structure 802, at least one third heat dissipation structure 803, and at least one fourth heat dissipation structure 804.

Each gate drive unit 221 may be connected to N gate lines, and N may be an integer greater than 1, for example, N is 4, 5, or 6 (N is 4 in the example of FIG. 2). A length of a first heat dissipation structure 801 along a second direction (the direction parallel to the data line, that is, the vertical direction in the figure) is L1, a length of a second heat dissipation structure 802 along the second direction is L2, and a length of the third heat dissipation structure 803 along the second direction is L3, which may be set as follows:

$N * L1 > L3 \geq (N-1) * L1$, for example, $3 * L1$ is approximately equal to L3, and L3 may be about 600 microns; or/and, $N * L2 > L1 \geq (N/2) * L2$.

Herein, the length of a heat dissipation structure along a certain direction refers to a length of a first heat dissipation groove (described later) of the heat dissipation structure along a certain direction.

In some exemplary embodiments, as shown in FIG. 2, in the direction parallel to the base substrate 10, a distance between the second heat dissipation structure 802 and the gate drive unit 221 may be less than a distance between the second heat dissipation structure 802 and the display region 100. The second heat dissipation structure 802 is disposed closer to the gate drive unit 221, which is beneficial for conducting out the heat of the output transistor of the gate drive unit 221.

In some exemplary embodiments, as shown in FIG. 2, the display region 100 includes at least one reference sub-pixel. A size of an effective light emitting area of a reference sub-pixel (i.e., the area defined by a pixel opening of the sub-pixel) in the second direction is a, and a distance between the effective light emitting area of a sub-pixel adjacent to the reference sub-pixel and the effective light emitting area of the reference sub-pixel in the second direction is b, which may be set as: $a + b \geq L1 > a$.

In some exemplary embodiments, as shown in FIG. 2, a second signal line extending along the second direction is provided between the display region 100 and the gate drive circuit 220 in the bezel region 200, and the second signal line is provided close to the edge of the display region 100. For example, the second signal line may be a frame start signal line STV, a third power supply line VGH, a second power supply line VSS (connected to a second electrode layer), etc.

In the direction parallel to the base substrate 10, the plurality of heat dissipation structures may be located between the second signal line and the gate drive circuit 220. There is a buffer of the second signal line (the second signal line is relatively less affected by changes in heat resistance and has relatively less interference with signals) between the display region 100 and the gate drive circuit 220, which is beneficial to slowing down the conduction of heat of the gate drive unit 221 to the display region 100.

In some exemplary embodiments, as shown in FIG. 2, a plurality of first heat dissipation structures 801 may be disposed close to the edge of the display region 100, and the plurality of first heat dissipation structures 801 may be disposed between a plurality of gate connection lines 240. The plurality of first heat dissipation structures 801 may be uniformly disposed in the second direction to facilitate uniform heat conduction to each row of sub-pixels.

An orthographic projection of a plurality of second heat dissipation structures 802 on the base substrate 10 is located between an orthographic projection of the plurality of first heat dissipation structures 801 on the base substrate 10 and an orthographic projection of the gate drive circuit 220 on the base substrate 10.

An orthographic projection of the at least one third heat dissipation structure 803 on the base substrate 10 is located between the orthographic projection of the plurality of first heat dissipation structures 801 on the base substrate 10 and the orthographic projection of the gate drive circuit 220 on the base substrate 10.

The fourth heat dissipation structure 804 may be provided between adjacent two-stage gate drive units 221.

In some exemplary embodiments, as shown in FIG. 4, Fig. 4 is a schematic diagram of a partial cross-sectional structure of a display substrate according to some exemplary embodiments. In the direction perpendicular to the base substrate 10, the display region 100 includes a drive structure layer 20 and a light emitting structure layer 30 sequentially stacked on the base substrate 10.

The drive structure layer 20 includes a plurality of pixel drive circuits, and a pixel drive circuits includes a plurality of transistors 210 and at least one storage capacitor. For example, in the direction perpendicular to the base substrate 10, the drive structure layer 20 may include a first metal layer, a buffer layer 21, a semiconductor layer, a gate insulation layer 22, a second metal layer, a passivation layer 24, and a planarization layer 25 sequentially disposed on the base substrate 10. The first metal layer may include a data line 232 and a light shielding block 231 (the light shielding block 231 may shield an active layer 211 of the transistor 210, preventing external light from irradiating the active layer 211 to affect the performance of the transistor 210), and the semiconductor layer may include the active layer 211 of the transistor 210. The second metal layer may include a gate electrode 212, a source electrode 213 and a drain electrode 214 of the transistor 210. The source electrode 213 is connected to an end of the active layer 211 through a first via disposed in the gate insulation layer 22, the source electrode 213 is also connected to the data line 232 through a second via penetrating the gate insulation layer 22 and the buffer layer 21, and the drain electrode 214 is connected to the other end of the active layer 211 through a third via disposed in the gate insulation layer 22. The planarization layer 25 is provided with a fourth via, the fourth via penetrates the passivation layer 24 and exposes the drain electrode 214, and the fourth via is configured such that a subsequently formed first electrode 31 is connected to the drain electrode 214 through the fourth via.

The base substrate 10 may be a flexible base substrate or may be a rigid base substrate. The rigid base substrate may be made of, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. The buffer layer 21, the gate insulation layer 22, and the passivation layer 24 may be inorganic insulation layers, which may be made of one or more of silicon oxide ($SiO_X$), silicon nitride ($SiN_x$) and silicon oxynitride ($SiO_xN_y$), and may be a single-layer structure or a multi-layer composite structure. The planarization layer 25 may be an organic insulation layer, and may be made of a resin material. The materials of the first metal layer and the second metal layer may be any one or more of silver (Ag), copper (Cu), aluminum (Al), and molybdenum (Mo), or an alloy material of the above metals, such as an aluminum neodymium alloy (AlNd) or a molybdenum niobium alloy (MoNb), and may be a single-layer structure, or a multi-layer composite structure, such as Mo/Cu/Mo, etc.

The light emitting structure layer 30 includes a plurality of light emitting elements, and a light emitting element is connected to corresponding one of the pixel drive circuits. For example, in the direction perpendicular to the base substrate 10, the light emitting structure layer 30 may include a first electrode layer, a pixel definition layer 32, a light emitting functional layer, and a second electrode layer 34 sequentially disposed. The first electrode layer includes a plurality of first electrodes 31, the pixel definition layer 32 is provided on a side of the plurality of first electrodes 31 away from the base substrate 10 and is provided with a plurality of pixel openings, a pixel opening exposes a first electrode 31, and the light emitting functional layer and the second electrode layer 34 are sequentially stacked on a side of the first electrode 31 away from the base substrate 10. The first electrode 31, the light emitting functional layer, and the second electrode layer 34 form a light emitting element. The light emitting functional layer includes an organic light emitting layer 33, and may further include any one or more film layers of a hole injection layer, a hole transport layer, and an electron block layer located between the first electrode 31 and the organic light emitting layer 33, and any one or more film layers of an electron injection layer, an electron transport layer, and a hole block layer located between the second electrode layer 34 and the organic light emitting layer 33. The plurality of sub-pixels include multiple types of sub-pixels, each type of sub-pixels emits light of a set color (the plurality of sub-pixels that emit light of the same color are the same type of sub-pixels), and the organic light emitting layer 33 of each type of sub-pixels may be configured to emit light of the set color under the action of voltages of the first electrode 31 and the second electrode layer 34. For example, the organic light emitting layer 33 of the light emitting element of the first sub-pixel P1, under the action of voltages of the first electrode 31 and the second electrode layer 34, can emit light of a first color (such as red). The organic light emitting layer 33 of the light emitting element of the second sub-pixel P2, under the action of the voltages of the first electrode 31 and the second electrode layer 34, can emit light of a second color (such as green). The organic light emitting layer 33 of the light emitting element of the third sub-pixel P3, under the action of the voltages of the first electrode 31 and the second electrode layer 34, can emit light of a third color (such as blue).

For example, a material of the first electrode 31 may include a transparent conductive material such as indium tin oxide (ITO) or indium zinc oxide (IZO), and the first electrode 31 may be a single-layer structure, or may be a multi-layer composite structure such as ITO/Ag/ITO, etc. A material of the pixel definition layer 32 may be polyimide, acrylic, polyethylene terephthalate, or the like. A material of the second electrode layer 34 may be any one or more of magnesium (Mg), silver (Ag), aluminum (Al), copper (Cu) and lithium (Li), or an alloy made of any one or more of the above metals.

The bezel region 200 is provided with at least one heat dissipation structure 80, and a heat dissipation structure 80 includes a first heat dissipation groove 87, and a first heat dissipation metal layer 81 and a second heat dissipation metal layer 82 disposed in the first heat dissipation groove 87. The second heat dissipation metal layer 82 is stacked on a side of the first heat dissipation metal layer 81 away from the base substrate 10, and the second heat dissipation metal layer 82 is disposed in the same layer as the second electrode layer 34. The second heat dissipation metal layer 82 may not be connected to the second electrode layer 34, or the second heat dissipation metal layer 82 and the second electrode layer 34 may be an integral connection structure.

In an embodiment of the present disclosure, by providing the heat dissipation structure 80, the heat generated by an electronic component in the bezel region 200 can be dissipated, and conduction of the heat to the display region 100 is reduced, so that the display abnormality problem caused by peripheral sub-pixels of the display region 100 being affected by the heat of the bezel region 200 can be reduced. In some embodiments, the heat dissipation structure 80 may be provided between the display region 100 and the gate drive circuit 220, so that when the heat generated by the gate drive unit 221 is conducted to the first heat dissipation groove 87, the heat can be conducted to the second heat dissipation metal layer 82 through the first heat dissipation metal layer 81 and conducted out from the second heat dissipation metal layer 82, reducing conduction of the heat to the display region 100. Thus the peripheral sub-pixels of the display region 100 may be less affected by the heat generated by the gate drive unit 221, and thereby the display abnormality (the peripheral sub-pixels are brightened up) problem caused by the peripheral sub-pixels of the display region 100 being affected by the heat generated by the gate drive unit 221 can be improved.

Herein, "A and B are disposed in a same layer" can be understood as meaning that the same thin film is subjected to the same patterning process to form A and B at the same time, or that the same thin film is subjected to the same patterning process to form A' and B' at the same time, A' is subjected to further processing (such as etching, etc.) to obtain A, and B' is subjected to further processing (such as etching, etc.) to obtain B.

In some exemplary embodiments, as shown in FIG. 4, the first heat dissipation metal layer 81 may be disposed in the same layer as the first electrode 31.

In some exemplary embodiments, as shown in FIG. 4, an orthographic projection of the first heat dissipation metal layer 81 on the base substrate 10 may include an orthographic projection of the first heat dissipation groove 87 on the base substrate 10. In this way, the thermal conductivity effect can be improved.

A size of the first heat dissipation metal layer 81 in the direction parallel to the base substrate 10 cannot be too small to ensure that the first heat dissipation groove 87 can be covered. Moreover, the size of the first heat dissipation metal layer 81 in the direction parallel to the base substrate 10 cannot be too large, and if the size is too large, short circuit with the gate drive circuit 220 or the second signal line readily occurs.

In some exemplary embodiments, as shown in FIG. 4, the heat dissipation structure 80 may further include a third heat dissipation metal layer 83. The first heat dissipation groove 87 exposes at least part of a surface of the third heat dissipation metal layer 83 away from the base substrate 10, and the first heat dissipation metal layer 81 is stacked on the surface of the third heat dissipation metal layer 83 away from the base substrate 10.

For example, as shown in FIG. 4, the third heat dissipation metal layer 83 may be one heat dissipation metal layer, and the third heat dissipation metal layer 83 may be disposed in the same layer as any metal layer or conductive structure (such as metal electrodes, metal signal lines, etc.) in the drive structure layer 20. For example, the third heat dissipation metal layer 83 may be disposed in the same layer as the gate electrode 212, the source electrode 213 and the drain electrode 214 (the second metal layer). Alternatively, the third heat dissipation metal layer 83 may be disposed in the same layer as the data line 232 and the light shielding block 231 (the first metal layer).

In some exemplary embodiments, as shown in FIG. 4, the first heat dissipation groove 87 includes a first groove and a second groove provided on a bottom surface of the first groove; an orthographic projection of the first groove on the base substrate 10 is larger than an orthographic projection of the second groove on the base substrate 10, and a stepped surface is formed between a side surface of the first groove and a side surface of the second groove. In the present embodiment, the first groove and the second groove may be formed in different patterning processes by different masks.

A slope angle of the side surface of the first groove is $\beta$, a slope angle of the side surface of the second groove is $\alpha$, a length of the first groove in a third direction is d2, and a length of the second groove in the third direction is d1. A depth of the first groove in the direction perpendicular to the base substrate 10 is h2, a depth of the second groove in the direction perpendicular to the base substrate 10 is h1, and a length of the first heat dissipation metal layer 81 in the third direction is S, wherein d1 < d2, then it may be set as follows:

$$d1 \leq S \leq 1.4*d2, \text{ or } d1 + (h1/\tan\alpha + h2/\tan\beta) \leq S \leq 1.4*d2.$$

Herein, the third direction is a direction parallel to the base substrate 10. For example, the third direction may be the first direction (a direction parallel to a gate line), the second direction (a direction parallel to a data line), or another direction.

In one example of the present embodiment, a length of the third heat dissipation metal layer 83 in the third direction is d3, and it may be set as d1 < d3 < d2, or d1 $\leq$ d3 $\leq$ d1 + (h1/tan$\alpha$ + h2/tan$\beta$) $\leq$ S. In this way, steps of the first heat dissipation metal layer 81 can be increased, so that the first heat dissipation metal layer 81 is in better contact with the second heat dissipation metal layer 82, improving the heat dissipation effect.

In one example of the present embodiment, it may be set as $\beta > \alpha$, for example, $\beta = 2\alpha$.

In some exemplary embodiments, as shown in FIG. 4, the bezel region 200 includes a composite insulation layer provided on the base substrate 10. The composite insulation layer may include at least one organic insulation layer and at least one inorganic insulation layer, and the first heat dissipation groove 87 is provided through the composite insulation layer.

In some examples of the present embodiment, as shown in FIG. 4, in the direction perpendicular to the base substrate 10, the bezel region 200 includes a buffer layer 21, a gate insulation layer 22, a third heat dissipation metal layer 83, a passivation layer 24 (inorganic insulation layer), and a planarization layer 25 (organic insulation layer), which are sequentially stacked on the base substrate 10. The first heat dissipation groove 87 is disposed through the planarization layer 25 and the passivation layer 24 and exposes at least part of the surface of the third heat dissipation metal layer 83, and the first heat dissipation metal layer 81 may be disposed on a side of the planarization layer 25 away from the base substrate 10, and may be disposed in the first heat dissipation groove 87 and be in contact with the third heat dissipation metal layer 83. The second heat dissipation metal layer 82 is disposed on a surface of the first heat dissipation metal layer 81 away from the base substrate 10 and at least partially located within the first heat dissipation groove 87. For example, the planarization layer 25 is provided with the first groove, and the passivation layer 24 is provided with the second groove.

For example, a thickness of the passivation layer 24 may be around 3700 Å; a thickness of the second metal layer on which the gate electrode 212, the source electrode 213 and the drain electrode 214 are located may be about 5100 Å; a total thickness of the passivation layer 24, the gate insulation layer 22 and the buffer layer 21 may be about 8900 Å; a thickness of the first metal layer on which the data line 232 and the light shielding block 231 are located may be about 6300 Å. When the third heat dissipation metal layer 83 is disposed in the same layer as the gate electrode 212, the source electrode 213 and the drain electrode 214 (the second metal layer), the heat of the passivation layer 24 can be effectively conducted out from the heat dissipation structure 80. When the third heat dissipation metal layer 83 is disposed in the same layer as the data line 232 and the light shielding block 231 (the first metal layer), the heat of the passivation layer 24, the gate insulation layer 22 and the buffer layer 21 can be effectively conducted out from the heat dissipation structure 80.

In some exemplary embodiments, as shown in FIG. 4, the bezel region 200 may further be provided with a heat insulation groove 70, and an orthographic projection of the heat insulation groove 70 on the base substrate 10 is located between orthographic projections of the display region 100 and the gate drive circuit on the base substrate 10.

For example, the heat insulation groove 70 may be provided close to the edge of the display region 100, and may be located on a side of the plurality of heat dissipation structures 80 facing the display region 100. The second signal line 71 may be provided in the heat insulation groove 70. For example, the second signal line 71 may be a second power supply line VSS, and is electrically connected to the second electrode layer 34 to provide a common voltage VSS signal to the second electrode layer 34. The second signal line 71 may be disposed in the same layer as the drain electrode 214.

In the present embodiment, the heat insulation groove 70 can play a role in preventing the heat generated by the gate drive circuit 220 from being conducted to the display region 100, reducing the effect of the heat generated by the gate drive circuit 220 on the peripheral sub-pixels of the display region 100.

In some exemplary embodiments, as shown in FIG. 5, which is a schematic diagram of a partial cross-sectional structure of a display substrate according to some further exemplary embodiments, the bezel region 200 is provided with at least one heat dissipation structure 80, and a heat dissipation structure 80 includes a first heat dissipation groove 87, and a first heat dissipation metal layer 81 and a second heat dissipation metal layer 82 disposed in the first heat dissipation groove 87. The second heat dissipation metal layer 82 is stacked on the side of the first heat dissipation metal layer 81 away from the base substrate 10; and the second heat dissipation metal layer 82 is disposed in the same layer as the second electrode layer 34.

The first heat dissipation groove 87 has an inverted trapezoidal cross section in the direction perpendicular to the base substrate 10, and a side surface of the first heat dissipation groove 87 is a slope surface. The first heat dissipation groove 87 may be formed in one patterning process by one mask. When a slope angle of the side surface of the first heat dissipation groove 87 is $\theta$, a length of a notch of the first heat dissipation groove 87 in the third direction is d5, a length of a bottom surface of the first heat dissipation groove 87 in the third direction is d4, wherein d5>d4. A length of the first heat dissipation metal layer 81 in the third direction is S, then it may be set as

$$d4 \leq S \leq 1.4*d5.$$

In one example of the present embodiment, the heat dissipation structure 80 may further include a third heat dissipation metal layer 83, the first heat dissipation groove 87 exposes at least part of the surface of the third heat dissipation metal layer 83 away from the base substrate 10, and the first heat dissipation metal layer 81 is stacked on the surface of the third heat dissipation metal layer 83 away from the base substrate 10. The length of the third heat dissipation metal layer 83 in the third direction is d3, and it may be set as d4≤d3≤d5≤S. In this way, steps of the first heat dissipation metal layer 81 can be increased, so that the first heat dissipation metal layer 81 is in better contact with the second heat dissipation metal layer 82, improving the heat dissipation effect.

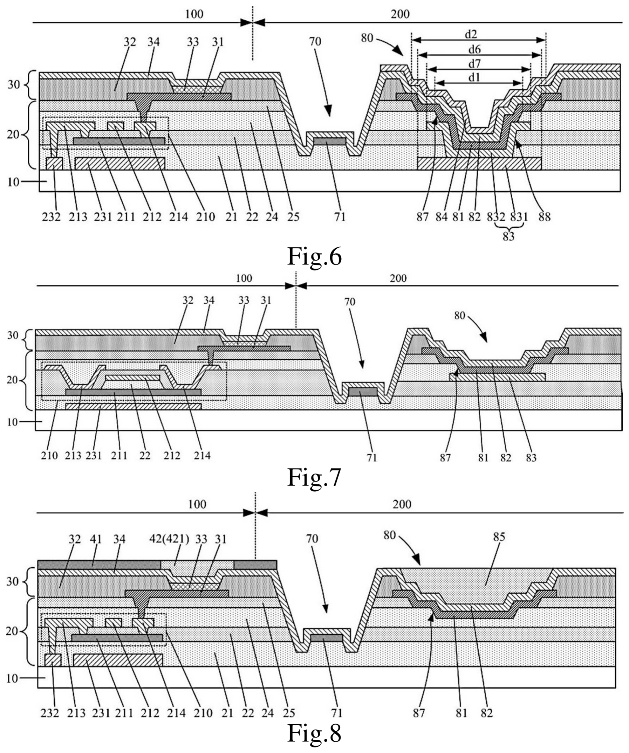

In some exemplary embodiments, as shown in FIG. 6, which is a schematic diagram of a partial cross-sectional structure of a display substrate according to some further exemplary embodiment, the bezel region 200 is provided with at least one heat dissipation structure 80. The heat dissipation structure 80 includes a first heat dissipation groove 87, and a first heat dissipation metal layer 81 and a second heat dissipation metal layer 82 disposed in the first heat dissipation groove 87, and the second heat dissipation metal layer 82 is stacked on a side of the first heat dissipation metal layer 81 away from the base substrate 10. The second heat dissipation metal layer 82 is disposed in the same layer as the second electrode layer 34. The second heat dissipation metal layer 82 may not be connected to the second electrode layer 34, or the second heat dissipation metal layer 82 and the second electrode layer 34 may be an integral connection structure.

The heat dissipation structure 80 may further include a third heat dissipation metal layer 83, the first heat dissipation groove 87 exposes at least part of a surface of the third heat dissipation metal layer 83 away from the base substrate 10, and the first heat dissipation metal layer 81 is stacked on the surface of the third heat dissipation metal layer 83 away from the base substrate 10.

The third heat dissipation metal layer 83 may include a plurality of sub-heat dissipation metal layers stacked, and any one of the sub-heat dissipation metal layers may be disposed in the same layer as a metal layer or a conductive structure (such as a metal electrode, a metal signal line, etc.) in the drive structure layer 20.

For example, as shown in FIG. 6, the third heat dissipation metal layer 83 may include a first sub-heat dissipation metal layer 831 and a second sub-heat dissipation metal layer 832 sequentially stacked in a direction away from the base substrate 10. The first heat dissipation metal layer 81 is stacked on a surface of the second sub-heat dissipation metal layer 832 away from the base substrate 10.

For example, as shown in FIG. 6, the heat dissipation structure 80 may further include a second heat dissipation groove 88, and the second heat dissipation groove 88 at least partially exposes a surface of the first sub-heat dissipation metal layer 831 away from the base substrate 10. The second sub-heat dissipation metal layer 832 is disposed in the second heat dissipation groove 88 and stacked on the surface of the first sub-heat dissipation metal layer 831 away from the base substrate 10.

A film layer structure of the drive structure layer 20 of the display region 100 in the present example may be the same as a film layer structure of the drive structure layer 20 of the display region 100 in the example of FIG. 4. Then, the first sub-heat dissipation metal layer 831 may be disposed in the same layer as the data line 232 and the light shielding block 231 (the first metal layer), and the second sub-heat dissipation metal layer 832 may be disposed in the same layer as the gate electrode 212, the source electrode 213 and the drain electrode 214 (the second metal layer). The first heat dissipation metal layer 81 may be disposed in the same layer as the first electrode 31.

For example, as shown in FIG. 6, in the direction perpendicular to the base substrate 10, the bezel region 200 may include a first sub-heat dissipation metal layer 831, a buffer layer 21, a gate insulation layer 22, a second sub-heat dissipation metal layer 832, a passivation layer 24, and a planarization layer 25, which are sequentially stacked on the base substrate 10. The second heat dissipation groove 88 is disposed through the gate insulation layer 22 and the buffer layer 21 and exposes at least part of the surface of the first sub-heat dissipation metal layer 831, and the second sub-heat dissipation metal layer 832 is disposed on a surface of the gate insulation layer 22 away from the base substrate 10 and is partially disposed in the second heat dissipation groove 88 and is in contact with the first sub-heat dissipation metal layer 831. The first heat dissipation groove 87 is provided through the planarization layer 25 and the passivation layer 24 and exposes at least part of the surface of the second sub-heat dissipation metal layer 832, and the first heat dissipation metal layer 81 is provided on a side of the planarization layer 25 away from the base rate 10, and is provided in the first heat dissipation groove 87 and is in contact with the second sub-heat dissipation metal layer 832. The second heat dissipation metal layer 82 is disposed on the surface of the first heat dissipation metal layer 81 away from the base substrate 10 and at least partially located within the first heat dissipation groove 87.

For example, as shown in FIG. 6, the first heat dissipation groove 87 includes a first groove and a second groove provided on the bottom surface of the first groove, and the orthographic projection of the first groove on the base substrate 10 is larger than the orthographic projection of the second groove on the base substrate 10. A stepped surface is formed between the side surface of the first groove and the side surface of the second groove. In the present embodiment, the first groove and the second groove may be formed in different patterning processes by different masks.

The length of the first groove in the third direction is d2, the length of the second groove in the third direction is d1, the length of the first sub-heat dissipation metal layer 831 in the third direction is d6, and the length of the second sub-heat dissipation metal layer 832 in the third direction is d7, and it may be set as: $d1<d7<d6<d2$. In this way, the step of the first heat dissipation metal layer 81 can be increased, so that the first heat dissipation metal layer 81 can be in better contact with the second heat dissipation metal layer 82, improving the heat dissipation effect.

In some exemplary embodiments, as shown in FIG. 6, the heat dissipation structure 80 may further include a fourth heat dissipation metal layer 84, and the fourth heat dissipation metal layer 84 is stacked on a side of the second heat dissipation metal layer 82 away from the base substrate 10. The fourth heat dissipation metal layer 84 is provided, so that the conduction of heat can be accelerated, improving the heat dissipation effect of the heat dissipation structure 80. For example, a metal layer may be provided on a side of the second electrode layer 34 of the display region 100 away from the base substrate 10, and the metal layer may be connected with the fourth heat dissipation metal layer 84 to form an integral structure. Alternatively, the fourth heat dissipation metal layer 84 may be a separately disposed metal layer.

In some exemplary embodiments, as shown in FIG. 6, edge corners of any one or more of any one sub-heat dissipation metal layer of the first heat dissipation metal layer 81, the second heat dissipation metal layer 82 and the third heat dissipation metal layer 83, and the fourth heat dissipation metal layer 84 are provided as chamfered structures. In this way, corners of heat dissipation metal layers can be prevented from being too sharp, which could otherwise lead to the accumulation of static electricity.

In some exemplary embodiments, as shown in FIG. 7, Fig. 7 is a schematic diagram of a partial cross-sectional structure of a display substrate according to some further exemplary embodiments. In the direction perpendicular to the base substrate 10, the display region 100 includes a drive structure layer 20 and a light emitting structure layer 30 sequentially stacked on the base substrate 10.

The drive structure layer 20 includes a plurality of pixel drive circuits, and a pixel drive circuit includes a plurality of transistors 210 and at least one storage capacitor. For example, in the direction perpendicular to the base substrate 10, the drive structure layer 20 may include a first metal layer, a buffer layer 21, a semiconductor layer, a gate insulation layer 22, a second metal layer, an interlayer insulation layer 23, a third metal layer, a passivation layer 24, and a planarization layer 25, which are sequentially disposed on the base substrate 10. The first metal layer may include a light shielding block 231, the semiconductor layer may include an active layer 211 of the transistor 210, the second metal layer may include a gate electrode 212 of the transistor 210, and the third metal layer may include a source electrode 213 and a drain electrode 214 of the transistor 210. The source electrode 213 is connected to one end of the active layer 211 through a first via provided in the interlayer insulation layer 23, and the drain electrode 214 is connected to the other end of the active layer 211 through a third via provided in the interlayer insulation layer 23. The planarization layer 25 is provided with a fourth via, the fourth via penetrates the passivation layer 24 and exposes the drain electrode 214, and the fourth via is configured such that the subsequently formed first electrode 31 is connected to the drain electrode 214 through the fourth via.

The display substrate illustrated in FIGS. 4 to 6 described above schematically illustrate a film layer structure of the drive structure layer 20, and FIG. 7 in present embodiment illustrates another film layer structure of the drive structure layer 20. An embodiment of the present disclosure does not limit the film layer structure of the drive structure layer 20.

As shown in FIG. 7, the light emitting structure layer 30 includes a plurality of light emitting elements. For example, in the direction perpendicular to the base substrate 10, the light emitting structure layer 30 may include a first electrode layer, a pixel definition layer 32, a light emitting functional layer, and a second electrode layer 34, which are sequentially disposed. The first electrode layer includes a plurality of first electrodes 31, and the pixel definition layer 32 is provided on a side of the plurality of first electrodes 31 away from the base substrate 10 and is provided with a plurality of pixel openings. A pixel opening exposes a first electrode 31, and the light emitting functional layer and the second electrode layer 34 are sequentially stacked on the side of the first electrodes 31 away from the base substrate 10. The first electrode 31, the light emitting functional layer and the second electrode layer 34 form a light emitting element.

In one example of the present embodiment, as shown in FIG. 7, the heat dissipation structure 80 may include the first heat dissipation metal layer 81, the second heat dissipation metal layer 82, and the third heat dissipation metal layer 83. The first heat dissipation metal layer 81 may be disposed in the same layer as the first electrode 31. The third heat dissipation metal layer 83 may be a heat dissipation metal layer, and the third heat dissipation metal layer 83 may be disposed in the same layer as any conductive structure (such as a metal electrode, a metal signal line, etc.) in the drive structure layer 20. For example, the third heat dissipation metal layer 83 may be disposed in the same layer as the source electrode 213 and the drain electrode 214 (the third metal layer), or the third heat dissipation metal layer 83 may be disposed in the same layer as the gate electrode 212 (the second metal layer), or, the third heat dissipation metal layer 83 may be disposed in the same layer as the light shielding block 231 (the first metal layer).

In some exemplary embodiments, the heat dissipation structure may further includes a filling layer disposed in the first heat dissipation groove, the filling layer is disposed on the side of the second heat dissipation metal layer away from the base substrate, or the filling layer is disposed between the first heat dissipation metal layer and the second heat dissipation metal layer. In this embodiment, the filling layer is provided, so that the heat dissipation structure can be kept planar with the display region as much as possible.

In one example of the present embodiment, as shown in FIG. 8, which is a schematic diagram of a partial cross-sectional structure of a display substrate according to some further exemplary embodiment, the heat dissipation structure 80 may further include a filling layer 85 provided in the first heat dissipation groove 87. The filling layer 85 is provided on a side of the second heat dissipation metal layer 82 away from the base substrate 10.

For example, as shown in FIG. 8, the display region 100 may further include a color filter layer 42 and a black matrix 41 provided on a side of the light emitting structure layer 30 away from the base substrate 10. The black matrix 41 is provided with a plurality of light transmitting holes, and the color filter layer 42 includes a plurality of filter units 421. The plurality of filter units 421 are provided in the plurality of light transmitting holes, and a filter unit 421 is provided opposite to a pixel opening region of the sub-pixel and transmits light of a set color.

The plurality of filter units 421 may include multiple types of filter units 421 that transmit light of different colors (the same type of filter units 421 transmits light of the same color), and each type of filter units 421 transmits light of a set color. The color of light transmitted by a filter unit 421 is the color of light emitted by a corresponding sub-pixel. For example, the plurality of sub-pixels of the display region 100 include a plurality of first sub-pixels P1 that emit light of the first color, a plurality of second sub-pixels P2 that emit light of the second color, and a plurality of third sub-pixels P3 that emit light of the third color. Then, the plurality of filter units 421 include a plurality of first filter units 421 that transmit light of the first color, a plurality of second filter units 421 that transmit light of the second color, and a plurality of third filter units 421 that transmit light of the third color. A first filter unit 421 is provided opposite to a pixel opening region of the first sub-pixel P1, a second filter unit 421 is provided opposite to a pixel opening region of the second sub-pixel P2, and a third filter unit 421 is provided opposite to a pixel opening region of the third sub-pixel P3.

The filling layer 85 may be a single film layer, and the filling layer 85 may be disposed in the same layer as any of the multiple types of filter units 421. Alternatively, the filling layer 85 may include a plurality of sub-filling layers, and each of the sub-filling layers may be disposed in the same layer as one of the multiple types of filter units 421. The plurality of sub-filling layers may be stacked in the direction perpendicular to the base substrate 10, or the plurality of sub-filling layers may be disposed at intervals in the direction parallel to the base substrate 10.

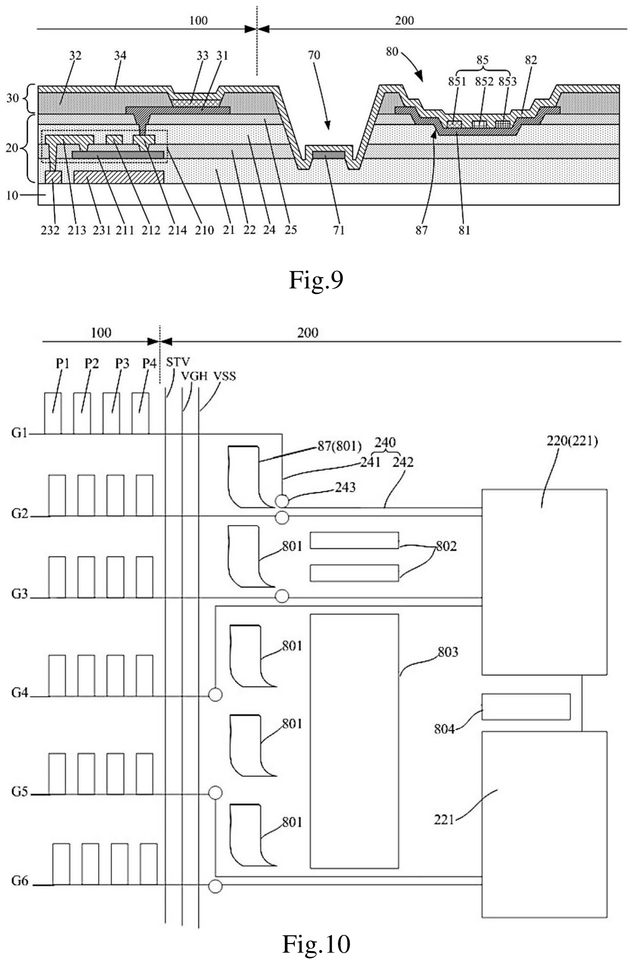

In one example of the present embodiment, as shown in FIG. 9, which is a schematic diagram of a partial cross-sectional structure of a display substrate according to some further exemplary embodiment, the heat dissipation structure 80 may further include a filling layer 85 disposed in the first heat dissipation groove 87. The filling layer 85 may be disposed between the first heat dissipation metal layer 81 and the second heat dissipation metal layer 82.

The plurality of sub-pixels include multiple types of sub-pixels, each type of sub-pixels emits light of a set color (the plurality of sub-pixels that emit light of the same color are the same type of sub-pixels), and the organic light emitting layer 33 of each type of sub-pixels may be configured to emit light of the set color under the action of voltages of the first electrode 31 and the second electrode layer 34. For example, the organic light emitting layer 33 of the light emitting element of the first sub-pixel P1 can emit light of the first color (such as red) under the action of voltages of the first electrode 31 and the second electrode layer 34. The organic light emitting layer 33 of the light emitting element of the second sub-pixel P2 can emit light of the second color (such as green) under the action of voltages of the first electrode 31 and the second electrode layer 34. The organic light emitting layer 33 of the light emitting element of the third sub-pixel P3 can emit light of the third color (such as blue) under the action of voltages of the first electrode 31 and the second electrode layer 34.

The filling layer 85 may be a single film layer, and the filling layer 85 may be disposed in the same layer as the organic light emitting layer 33 of any type of sub-pixels. Alternatively, the filling layer 85 may include a plurality of sub-filling layers, and each of the sub-filling layers may be disposed in the same layer as the organic light emitting layer 33 of a sub-pixel. The plurality of sub-filling layers may be stacked in the direction perpendicular to the base substrate 10, or the plurality of sub-filling layers may be disposed at intervals in the direction parallel to the base substrate 10.

For example, as illustrated in FIG. 9, the filling layer 85 may include a first sub-filling layer 851, a second sub-filling layer 852 and a third sub-filling layer 853, which are disposed at intervals in the direction parallel to the base substrate 10. The first sub-filling layer 851 may be disposed in the same layer as the organic light emitting layer 33 of the first sub-pixel P1, the second sub-filling layer 852 may be disposed in the same layer as the organic light emitting layer 33 of the second sub-pixel P2, and the third sub-filling layer 853 may be disposed in the same layer as the organic light emitting layer 33 of the third sub-pixel P3.

In some exemplary embodiments, as shown in FIG. 10, which is a schematic diagram of a partial planar structure of a display substrate according to some other exemplary embodiment, the bezel region 200 is provided with one or more heat dissipation structures 80, and an orthographic projection of at least one of the heat dissipation structures 80 on the base substrate 10 is located between orthographic projections of the display region 100 and the gate drive circuit 220 on the base substrate 10. The plurality of heat dissipation structures 80 may include any one or more of at least one first heat dissipation structure 801, at least one second heat dissipation structure 802, at least one third heat dissipation structure 803, and at least one fourth heat dissipation structure 804. In the present embodiment, the manner of distribution of the plurality of heat dissipation structures 80 may be the same as the manner of distribution in the example of FIG. 2. The plurality of first heat dissipation structures 801 may be provided close to the edge of the display region 100.

In some examples of the present embodiment, a cross-sectional shape of the first heat dissipation groove 87 of the heat dissipation structure 80 in the direction parallel to the base substrate 10 may be a regular shape such as a rectangle, a trapezoid, a circle or an ellipse, or may be an irregular shape. The cross-sectional shapes of the first heat dissipation grooves 87 of different heat dissipation structures in the direction parallel to the base substrate 10 may be the same or different.

In some examples of the present embodiment, a cross-sectional shape of the first heat dissipation groove 87 of the first heat dissipation structure 801 in the direction parallel to the base substrate 10 may be an irregular shape, and a side surface of the first heat dissipation groove 87 of the first heat dissipation structure 801 close to the display region 100 may be a curved surface or an inclined surface or the like. In this way, an area of the side surface of the first heat dissipation groove 87 of the first heat dissipation structure 801 close to the display region 100 can be increased, which is conducive to conducting away more heat close to the display region 100.

In some examples of the present embodiment, the cross-sectional shape of the first heat dissipation groove 87 of the at least one heat dissipation structure 80 in the direction parallel to the base substrate 10 may be the same as the shape of any filter unit 421. This facilitates the use of any filter unit 421 as the filling layer 85 to be filled into the first heat dissipation groove 87.

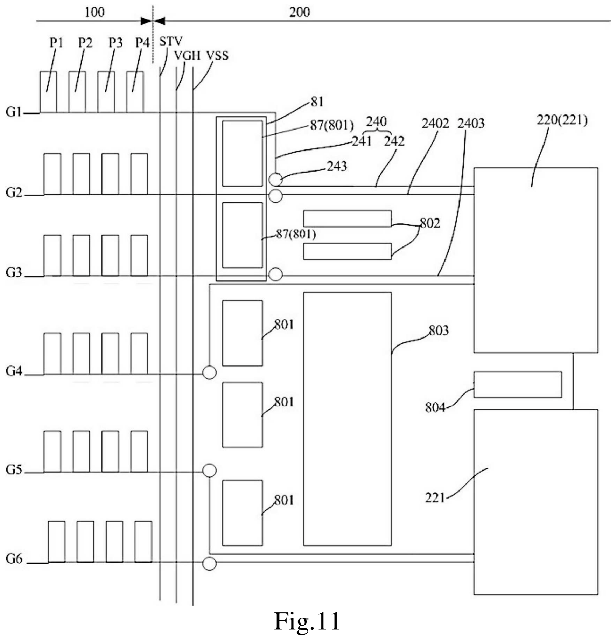

In some exemplary embodiments, as shown in FIG. 11, which is a schematic diagram of a partial planar structure of a display substrate according to some further exemplary embodiments, the bezel region 200 is provided with a gate connection line 240, and the gate line is connected to the gate drive unit 221 through the gate connection line 240. The first heat dissipation metal layers 81 of at least two of the heat dissipation structures 80 are connected as an integral structure, and overlap with at least two adjacent gate connection lines 240 connected to the same gate drive unit 221. In other embodiments, the first heat dissipation metal layers 81 of different heat dissipation structures 80 may not be connected.

The first heat dissipation metal layers 81 of at least two of the heat dissipation structures 80 are connected as an integral structure, and the first heat dissipation metal layers 81 connected as an integral structure can completely cover the first heat dissipation grooves 87 of at least two of the heat dissipation structures 80 where the first heat dissipation metal layers 81 are located. The first heat dissipation groove 87 may not overlap with the gate connection line 240.

In this embodiment, the first heat dissipation metal layers 81 of the plurality of heat dissipation structures 80 corresponding to the same gate drive unit 221 are connected as an integral structure, which is beneficial for uniform heat dissipation of heat generated by the same gate drive unit 221.

In the present embodiment, when any one of the at least two adjacent gate connection lines 240 connected to the same gate drive unit 221 is disconnected, the first heat dissipation metal layers 81 connected as an integral structure may be used for repair. Specifically, the first heat dissipation metal layers 81 connected as an integral structure may be connected to the gate connection line 240 that is disconnected (for example, laser drilling repair) and connected to the gate

EP 4 651 694 A1

connection line 240 that is not disconnected (for example, laser drilling repair). That is, the gate connection line 240 that is disconnected and the gate connection line 240 that is not disconnected are connected through the first heat dissipation metal layers 81 connected as an integral structure. In this way, a signal of the gate drive unit 221 may be transmitted to a gate line of the display region 100 connected to the gate connection line 240 that is disconnected, through the gate connection line 240 that is not disconnected, the first heat dissipating metal layers 81 as the integral structure and the gate connection line 240 that is disconnected, which are connected as a conductive path. In addition, the present embodiment is advantageous for conducting the heat of the gate connection line 240 to the first heat dissipation groove 87 through the first heat dissipation metal layers 81 as the integral structure and performing heat dissipation.

For example, the first heat dissipation metal layers 81 of at least two first heat dissipation structures 801 are connected as an integral structure, and overlap with adjacent second gate connection lines 2402 (connected to the second gate line G2 of the display region 100) and third gate connection lines 2403 (connected to the third gate line G3 of the display region 100). Both the second gate connection line 2402 and the third gate connection line 2403 are connected to the first gate drive unit 221. In this way, for example, when the second gate connection line 2402 is disconnected, the first heat dissipation metal layers 81 connected as an integral structure can be connected to the second gate connection line 2402 and the third gate connection line 2403, respectively, by laser drilling. Consequently, the signal of the first gate drive unit 221 can be transmitted to the second gate line G2 of the display region 100 through the third gate connection line 2403, the first heat dissipation metal layers 81 as the integral structure and the second gate connection line 2402.

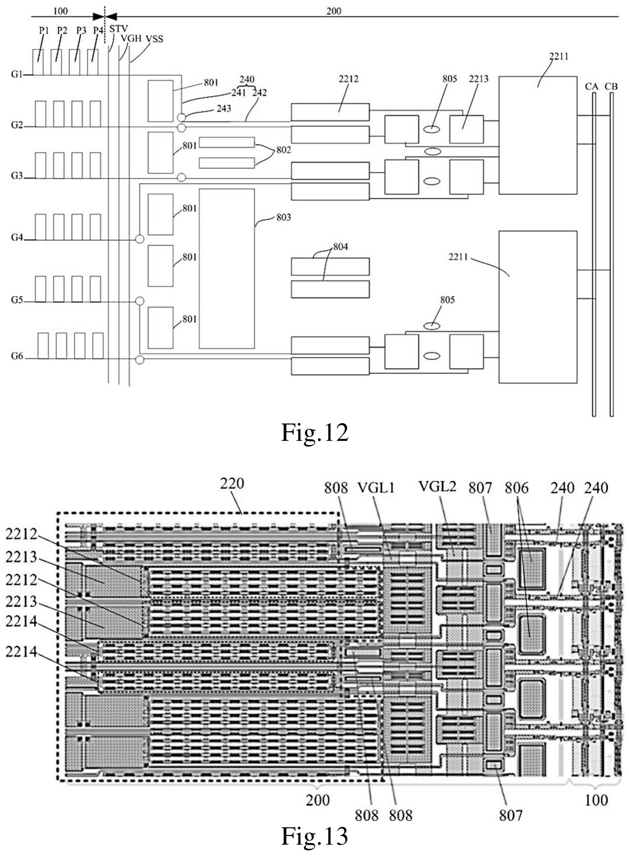

In some exemplary embodiments, as shown in FIGS. 2 and 12, FIG. 12 is a schematic diagram of a partial planar structure of a display substrate according to some further exemplary embodiments, the bezel region 200 is provided with a gate drive circuit 220, and the gate drive circuit 220 includes a plurality of cascaded gate drive units 221 configured to provide a drive signal to a plurality of gate lines (six lines G1 to G6 are schematically shown). Each gate drive unit 221 may be connected to the plurality (four for example) of gate lines. Each gate drive unit 221 may include an input module 2211 and a plurality of output modules. An output module may include an output transistor 2212 and an output capacitor 2213, the output transistor 2212 of each output module is connected to corresponding one gate connection line 240, and the one gate connection line 240 is connected to corresponding one gate line, that is, the output transistor 2212 being connected to corresponding one gate line. The plurality of output modules of each gate drive unit 221 may be located on a side of the input module 2211 facing the display region 100, and each gate drive unit 221 may be connected to a first clock signal line CA and a second clock signal line CB located on a side of the input module 2211 away from the display region 100.

For example, the bezel region 200 is provided with a plurality of heat dissipation structures, and the plurality of heat dissipation structures may include at least one first heat dissipation structure 801, at least one second heat dissipation structure 802, at least one third heat dissipation structure 803, at least one fourth heat dissipation structure 804, and at least one fifth heat dissipation structure 805.

A plurality of first heat dissipation structures 801 may be disposed close to the edge of the display region 100, and may be uniformly disposed in the second direction. An orthographic projection of a plurality of second heat dissipation structures 802 on the base substrate 10 is located between an orthographic projection of the plurality of first heat dissipation structures 801 on the base substrate 10 and an orthographic projection of the gate drive circuit 220 on the base substrate 10. An orthographic projection of the at least one third heat dissipation structure 803 on the base substrate 10 is located between the orthographic projection of the plurality of first heat dissipation structures 801 on the base substrate 10 and the orthographic projection of the gate drive circuit 220 on the base substrate 10. A fourth heat dissipation structure 804 may be disposed between adjacent two-stage gate drive units 221. For example, the fourth heat dissipation structure 804 may be disposed between output transistors 2212 of the adjacent two-stage gate drive units 221. A fifth heat dissipation structure 805 may be provided between a plurality of output capacitors 2213 of a plurality of output modules of the gate drive unit 221.

The cross-sectional shape of the first heat dissipation groove 87 of the plurality of heat dissipation structures 80 in the direction parallel to the base substrate 10 may be one or more of a rectangle, a trapezoid, a circle, an ellipse, and the like. In some examples, the cross-sectional shapes of the first heat dissipation grooves 87 of the first heat dissipation structure 801, the second heat dissipation structure 802, the third heat dissipation structure 803 and the fourth heat dissipation structure 804 in the direction parallel to the base substrate 10 may be a rectangle. The cross-sectional shape of the first heat dissipation groove 87 of the fifth heat dissipation structure 805 in the direction parallel to the base substrate 10 may be a square, a circle, or an ellipse.

In some exemplary embodiments, as shown in FIG. 13, which is a schematic diagram of a partial planar structure of a display substrate according to some exemplary embodiments, the display substrate includes a display region 100 and a bezel region 200 located on the periphery of the display region 100. The bezel region 200 is provided with a gate drive circuit 220, the gate drive circuit 220 includes a plurality of cascaded gate drive units configured to provide drive signals to a plurality of gate lines of the display region 100, and each gate drive unit may be provided with a plurality of gate drive signal output terminals to be connected to the plurality of gate lines. Each gate drive unit may include an input module, a plurality of output modules, and a pull-down module, the output module may include an output transistor 2212 and an output capacitor 2213, and the pull-down includes at least one pull-down transistor 2214.

The bezel region 200 is further provided with a first low-level signal line VGL1, a second low-level signal line VGL2, a plurality of clock signal lines, and the like, extending along the second direction (the vertical direction in the figure). The first low-level signal line VGL1 and the second low-level signal line VGL2 may be located between the gate drive circuit 220 and the display region 100, and the first low-level signal line VGL1 may be provided closer to the gate drive circuit 220 than the second low-level signal line VGL2.

One gate drive signal output terminal of the gate drive unit may correspond to one output transistor 2212. For example, a first pole of the output transistor 2212 is connected with a corresponding clock signal line, and a second pole of the output transistor 2212 is connected with a corresponding gate drive signal output terminal. The output transistor 2212 is configured to, under control of a signal received by a control terminal thereof, control an electrical connection between the corresponding gate drive signal output terminal and the clock signal line to be turned on or off.

One gate drive signal output terminal of the gate drive unit may correspond to at least one pull-down transistor 2214. For example, a first pole of the pull-down transistor 2214 is connected with a corresponding gate drive signal output terminal, and a second pole of the pull-down transistor 2214 is connected with the second low-level signal line VGL2. The pull-down transistor 2214 is configured to, under control of a signal received by the control terminal thereof, control an electrical connection between the corresponding gate drive signal output terminal and the second low-level signal line VGL2 to be turned on or off.

The bezel region 200 is further provided with a plurality of heat dissipation structures, and an orthographic projection of the heat dissipation structure 80 on the base substrate 10 is located between orthographic projections of the display region 100 and the gate drive circuit 220 on the base substrate 10. The plurality of heat dissipation structures may include any one or more of at least one sixth heat dissipation structure 806, at least one seventh heat dissipation structure 807, and at least one eighth heat dissipation structure 808.

For example, the plurality of heat dissipation structures 80 may include a plurality of sixth heat dissipation structures 806, and the plurality of sixth heat dissipation structures 806 are disposed close to the edge of the display region 100 and sequentially disposed in the second direction. The sixth heat dissipation structures 806 may be located between adjacent gate connection lines 240.

The plurality of heat dissipation structures 80 may include a plurality of seventh heat dissipation structures 807. The plurality of seventh heat dissipation structures 807 may be located between the second low-level signal line VGL2 and the plurality of sixth heat dissipation structures 806, and the plurality of seventh heat dissipation structures 807 may be sequentially disposed in the second direction. The sizes of the plurality of seventh heat dissipation structures 807 may be the same or different. For example, some of the seventh heat dissipation structures 807 have a length of about 60 $\mu$m in the first direction (the direction parallel to the gate lines, i.e. the horizontal direction in the figure) and a length of about 35 $\mu$m in the second direction (the direction parallel to the data lines, i.e. the vertical direction in the figure), and some of the seventh heat dissipation structures 807 have a length of about 65 $\mu$m in the first direction and a length of about 155 $\mu$m in the second direction.

The plurality of heat dissipation structures 80 may include a plurality of eighth heat dissipation structures 808. The plurality of eighth heat dissipation structures 808 may be located between the first low-level signal line VGL1 and the gate drive circuit 220, and the plurality of eighth heat dissipation structures 808 may be sequentially disposed in the second direction and may be disposed close to the output transistor 2212 and the pull-down transistor 2214. The sizes of the plurality of eighth heat dissipation structures 808 may be the same or different. For example, some of the eighth heat dissipation structures 808 have a length of about 150 $\mu$m in the first direction and a length of about 30 $\mu$m in the second direction, and some of the eighth heat dissipation structures 808 have a length of about 150 $\mu$m in the first direction and a length of about 15 $\mu$m in the second direction.

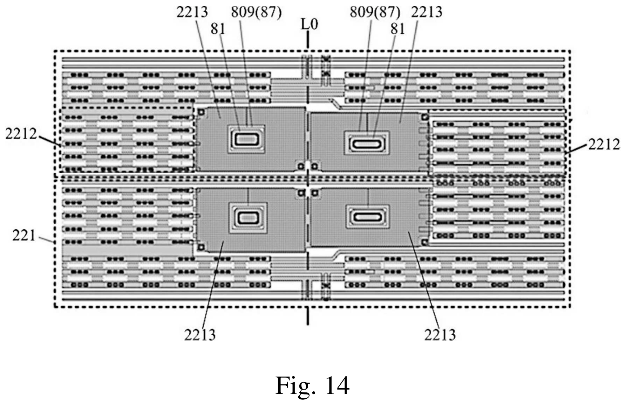

In some exemplary embodiments, as shown in FIG. 14, Fig. 14 is a schematic diagram of a partial planar structure of a display substrate according to some exemplary embodiments. Each gate drive unit 221 may be provided with four output modules, and each output module may include an output transistor 2212 and an output capacitor 2213.

The heat dissipation structure may include at least one ninth heat dissipation structure 809. An orthographic projection of the ninth heat dissipation structure 809 on the base substrate 10 may overlap with an orthographic projection of the output capacitor 2213 on the base substrate 10. The ninth heat dissipation structure 809 may be located on a side of the output capacitor 2213 away from the base substrate 10.

Alternatively, an orthographic projection of the first heat dissipation groove 87 of the ninth heat dissipation structure 809 on the base substrate 10 may be surrounded by the orthographic projection of the output capacitor 2213 on the base substrate 10. Two electrode plates of the output capacitor 2213 may be provided with an opening. An orthographic projection of the opening on the base substrate 10 may include the orthographic projection of the first heat dissipation groove 87 of the ninth heat dissipation structure 809 on the base substrate 10, and may include the orthographic projection of the first heat dissipation metal layer 81 of the ninth heat dissipation structure 809 on the base substrate 10.

Four output capacitors 2213 of each gate drive unit 221 may be arranged in two rows and two columns and close to each other, and two output transistors 2212 of four output transistors 2212 of each gate drive unit 221 are located on a side of the four output capacitors 2213 close to the display region 100, and the other two output transistors 2212 are located on a side of the four output capacitors 2213 away from the display region 100. The second electrode layer of the display region may be an integral connection structure with the second heat dissipation metal layer of the heat dissipation structure of the bezel region. An edge L0 of the second electrode layer of the display region may extend to the bezel region, and may be located between two output capacitors 2213 and the other two output capacitors 2213 of the gate drive unit 221 in the direction parallel to the base substrate.

An embodiment of the present disclosure further provides a display apparatus, which includes the display substrate according to any one of the previous embodiments. The display apparatus may be any product or component with a display function, such as a mobile phone, a tablet computer, a television, a display, a laptop computer, a digital photo frame, and a navigator.

## Claims

1. A display substrate, comprising a display region and a bezel region located around the display region, wherein the display region comprises a plurality of sub-pixels disposed on a base substrate, a sub-pixel comprises a light emitting element, and the light emitting element comprises a first electrode, a light emitting functional layer and a second electrode layer sequentially stacked in a direction away from the base substrate; and

   the bezel region is provided with at least one heat dissipation structure, and the heat dissipation structure comprises a first heat dissipation groove, and a first heat dissipation metal layer and a second heat dissipation metal layer arranged in the first heat dissipation groove; the second heat dissipation metal layer is stacked on a side of the first heat dissipation metal layer away from the base substrate, and the second heat dissipation metal layer is disposed in the same layer as the second electrode layer.

2. The display substrate according to claim 1, wherein the first heat dissipation metal layer is disposed in the same layer as the first electrode.

3. The display substrate according to claim 1, wherein an orthographic projection of the first heat dissipation metal layer on the base substrate comprises an orthographic projection of the first heat dissipation groove on the base substrate.

4. The display substrate according to claim 1, wherein the heat dissipation structure further comprises a third heat dissipation metal layer, the first heat dissipation groove exposes at least part of a surface of the third heat dissipation metal layer away from the base substrate, and the first heat dissipation metal layer is stacked on the surface of the third heat dissipation metal layer away from the base substrate.

5. The display substrate according to claim 4, wherein in a direction perpendicular to the base substrate, the display region comprises a drive structure layer and a light emitting structure layer sequentially stacked on the base substrate;

   the drive structure layer comprises a plurality of pixel drive circuits, the light emitting structure layer comprises a plurality of light emitting elements, and the light emitting element is connected to a pixel drive circuit; the drive structure layer comprises a plurality of metal layers disposed sequentially in the direction away from the base substrate; and
   the third heat dissipation metal layer is disposed in the same layer as any metal layer in the drive structure layer; or, the third heat dissipation metal layer comprises a plurality of sub-heat dissipation metal layers stacked, and any one of the sub-heat dissipation metal layers is disposed in the same layer as the metal layer in the drive structure layer.

6. The display substrate according to claim 1, wherein the first heat dissipation groove comprises a first groove and a second groove disposed on a bottom surface of the first groove; an orthographic projection of the first groove on the base substrate is larger than an orthographic projection of the second groove on the base substrate, and a stepped surface is formed between a side surface of the first groove and a side surface of the second groove.

7. The display substrate according to claim 6, wherein a slope angle of the side surface of the first groove is $\beta$, a slope angle of the side surface of the second groove is $\alpha$, a length of the first groove in a third direction is d2, a length of the second groove in the third direction is d1, a depth of the first groove in a direction perpendicular to the base substrate is h2, a depth of the second groove in the direction perpendicular to the base substrate is h1, a length of the first heat dissipation metal layer in the third direction is S, and the third direction is a direction parallel to the base substrate; wherein d1 < d2, S satisfies the following relationship:

$$d1 \leq S \leq 1.4*d2, \text{ or } d1 + (h1/\tan\alpha + h2/\tan\beta) \leq S \leq 1.4*d2.$$

8. The display substrate according to claim 7, wherein the heat dissipation structure further comprises a third heat dissipation metal layer, the first heat dissipation groove exposes at least part of a surface of the third heat dissipation metal layer away from the base substrate, and the first heat dissipation metal layer is stacked on the surface of the third heat dissipation metal layer away from the base substrate; and

a length of the third heat dissipation metal layer in the third direction is d3, and d3 satisfies the following relationship: $d1 < d3 < d2$, or $d1 \leq d3 \leq d1 + (h1/\tan\alpha + h2/\tan\beta) \leq S$.

9. The display substrate according to claim 6, wherein the heat dissipation structure further comprises a third heat dissipation metal layer, and the first heat dissipation groove exposes at least part of a surface of the third heat dissipation metal layer away from the base substrate;

the third heat dissipation metal layer comprises a first sub-heat dissipation metal layer and a second sub-heat dissipation metal layer sequentially stacked along the direction away from the base substrate; the first heat dissipation metal layer is stacked on a surface of the second sub-heat dissipation metal layer away from the base substrate; and

a length of the first groove in a third direction is d2, a length of the second groove in the third direction is d1, a length of the first sub-heat dissipation metal layer in the third direction is d6, a length of the second sub-heat dissipation metal layer in the third direction is d7, and the third direction is a direction parallel to the base substrate; wherein $d1 < d7 < d6 < d2$.

10. The display substrate according to claim 1, wherein a length of a notch of the first heat dissipation groove in a third direction is d5, a length of a bottom surface of the first heat dissipation groove in the third direction is d4, a length of the first heat dissipation metal layer in the third direction is S, and the third direction is a direction parallel to the base substrate; wherein $d5 > d4$, $d4 \leq S \leq 1.4*d5$.

11. The display substrate according to claim 10, wherein the heat dissipation structure further comprises a third heat dissipation metal layer, the first heat dissipation groove exposes at least part of a surface of the third heat dissipation metal layer away from the base substrate, and the first heat dissipation metal layer is stacked on the surface of the third heat dissipation metal layer away from the base substrate; and

a length of the third heat dissipation metal layer in the third direction is d3, wherein $d4 \leq d3 \leq d5 \leq S$.

12. The display substrate according to claim 1, wherein the heat dissipation structure further comprises a fourth heat dissipation metal layer, and the fourth heat dissipation metal layer is stacked on a side of the second heat dissipation metal layer away from the base substrate.

13. The display substrate according to claim 1, wherein the heat dissipation structure further comprises a filling layer disposed in the first heat dissipation groove, and the filling layer is disposed on a side of the second heat dissipation metal layer away from the base substrate, or the filling layer is disposed between the first heat dissipation metal layer and the second heat dissipation metal layer.

14. The display substrate according to claim 13, wherein the filling layer is a single film layer; or the filling layer comprises a plurality of sub-filling layers, and the plurality of sub-filling layers are stacked in a direction perpendicular to the base substrate, or the plurality of sub-filling layers are disposed at intervals in a direction parallel to the base substrate.

15. The display substrate according to claim 14, wherein in the direction perpendicular to the base substrate, the display region comprises a drive structure layer and a light emitting structure layer sequentially stacked on the base substrate; the drive structure layer comprises a plurality of pixel drive circuits, and the light emitting structure layer comprises a plurality of light emitting elements;

the display region further comprises a color filter layer and a black matrix disposed on a side of the light emitting structure layer away from the base substrate; the black matrix is provided with a plurality of light transmitting holes, the color filter layer comprises a plurality of filter units, and the plurality of filter units are arranged in the plurality of light transmitting holes; the plurality of filter units comprise multiple types of filter units that transmit light of different colors, and each type of the filter units transmits light of a set color; and

the filling layer is a single film layer, and the filling layer is disposed in the same layer as any of the multiple types of filter units; or, the filling layer comprises a plurality of sub-filling layers, and each of the sub-filling layers is disposed in the same layer as one type of the multiple types of filter units.

16. The display substrate according to claim 14, wherein the light emitting functional layer comprises an organic light emitting layer; the plurality of sub-pixels comprise multiple types of sub-pixels, each type of sub-pixels emits light of a set color, and the organic light-emitting layer of each type of sub-pixels is configured to emit light of the set color under an action of voltages of the first electrode and the second electrode layer; and
the filling layer is a single film layer, and the filling layer is disposed in the same layer as the organic light-emitting layer of any type of sub-pixels; or, the filling layer comprises a plurality of sub-filling layers, and each of the sub-filling layers is disposed in the same layer as the organic light-emitting layer of one type of sub-pixels.

17. The display substrate according to claim 1, wherein the display region further comprises a plurality of gate lines extending along a first direction and a plurality of data lines extending along a second direction; the bezel region is further provided with a gate drive circuit, and the gate drive circuit comprises a plurality of cascaded gate drive units configured to provide a drive signal to the plurality of gate lines; and
an orthographic projection of the at least one heat dissipation structure on the base substrate is located between orthographic projections of the display region and the gate drive circuit on the base substrate.

18. The display substrate according to claim 17, wherein the at least one heat dissipation structure comprises at least one first heat dissipation structure, at least one second heat dissipation structure, and at least one third heat dissipation structure; and
the gate drive unit is connected to N of the gate lines, N being an integer greater than 1; a length of the first heat dissipation groove of the first heat dissipation structure in the second direction is L1, a length of the first heat dissipation groove of the second heat dissipation structure in the second direction is L2, and a length of the first heat dissipation groove of the third heat dissipation structure in the second direction is L3, wherein: $N * L1 > L3 \geq (N-1)*L1$; or/and, $N*L2 > L1 \geq (N/2)*L2$.

19. The display substrate according to claim 17, wherein a second signal line extending along the second direction is disposed between the display region and the gate drive circuit in the bezel region, and the second signal line is disposed close to an edge of the display region; a plurality of heat dissipation structures are positioned between the second signal line and the gate drive circuit in a direction parallel to the base substrate.

20. The display substrate according to claim 17, wherein the bezel region is further provided with a gate connection line, and a gate line is connected to a gate drive unit through the gate connection line; and
first heat dissipation metal layers of at least two heat dissipation structures are connected as an integral structure and overlap with at least two adjacent gate connection lines connected to a same gate drive unit.

21. The display substrate according to claim 17, wherein a gate drive unit comprises a plurality of output modules, and an output module comprises an output transistor and an output capacitor; and
the at least one heat dissipation structure comprises at least one fourth heat dissipation structure and at least one fifth heat dissipation structure; the fourth heat dissipation structure is disposed between adjacent two-stage gate drive units, and the fifth heat dissipation structure is disposed between a plurality of output capacitors of the gate drive unit.

22. The display substrate according to claim 17, wherein the bezel region is further provided with a heat insulation groove, and an orthographic projection of the heat insulation groove on the base substrate is located between orthographic projections of the display region and the gate drive circuit on the base substrate.

23. A display apparatus, comprising the display substrate according to any one of claims 1 to 22.

Fig.1

Fig.2

Fig.3

Fig.4

Fig.5

Fig.6

Fig.7

Fig.8

Fig.9

Fig.10

Fig.11

**EP 4 651 694 A1**

Fig.12

Fig.13

23

Fig. 14

## INTERNATIONAL SEARCH REPORT

| International application No. |
| --- |
| **PCT/CN2024/082619** |

| A. | CLASSIFICATION OF SUBJECT MATTER |
| --- | --- |

H10K59/80(2023.01)i

According to International Patent Classification (IPC) or to both national classification and IPC

| B. | FIELDS SEARCHED |
| --- | --- |

Minimum documentation searched (classification system followed by classification symbols)

IPC: H10K, H01L

Documentation searched other than minimum documentation to the extent that such documents are included in the fields searched

Electronic data base consulted during the international search (name of data base and, where practicable, search terms used)

CNTXT, ENTXTC, ENTXT, DWPI, WPABS, CNKI, IEEE: 边框, 散热, 槽, 第二, 金属层, bezel, heat dissipation, groove, second, metal layer

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | CN 113809112 A (WUHAN TIANMA MICROELECTRONICS CO., LTD.) 17 December 2021 (2021-12-17)<br>description, paragraphs 36-120, and figures 1-24 | 1-5, 12-13, 17, 19-22 |
| Y | CN 115347129 A (BEIJING BOE TECHNOLOGY DEVELOPMENT CO., LTD. et al.) 15 November 2022 (2022-11-15)<br>description, paragraphs 42-77, and figures 1-8 | 1-5, 12-13, 17, 19-22 |
| A | JP 2010107810 A (SEIKO EPSON CORP.) 13 May 2010 (2010-05-13)<br>entire document | 1-23 |
| A | WO 2022225316 A1 (SAMSUNG DISPLAY CO., LTD.) 27 October 2022 (2022-10-27)<br>entire document | 1-23 |
| A | CN 110048014 A (YUNGU (GU'AN) TECHNOLOGY CO., LTD.) 23 July 2019 (2019-07-23)<br>entire document | 1-23 |
| A | CN 103779378 A (AU OPTRONICS CORP.) 07 May 2014 (2014-05-07)<br>entire document | 1-23 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **04 June 2024** | **11 June 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| International application No. |
| --- |
| **PCT/CN2024/082619** |

| Patent document cited in search report | | | Publication date (day/month/year) | Patent family member(s) | | | Publication date (day/month/year) |
| --- | --- | --- | --- | --- | --- | --- | --- |
| CN | 113809112 | A | 17 December 2021 | WO | 2023010696 | A1 | 09 February 2023 |
| CN | 115347129 | A | 15 November 2022 | CN | 216120359 | U | 22 March 2022 |
| | | | | WO | 2022237096 | A1 | 17 November 2022 |
| JP | 2010107810 | A | 13 May 2010 | | None | | |
| WO | 2022225316 | A1 | 27 October 2022 | US | 2022343810 | A1 | 27 October 2022 |
| | | | | KR | 20220145969 | A | 01 November 2022 |
| | | | | CN | 117204142 | A | 08 December 2023 |
| CN | 110048014 | A | 23 July 2019 | CN | 110048014 | B | 25 February 2022 |
| CN | 103779378 | A | 07 May 2014 | | None | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310485396